(19) Europäisches Patentamt
European Patent Office
Office européen des brevets

(11) **EP 4 245 734 A1**

(12) **EUROPEAN PATENT APPLICATION**

(43) Date of publication:
**20.09.2023  Bulletin 2023/38**

(21) Application number: **23162320.8**

(22) Date of filing: **16.03.2023**

(51) International Patent Classification (IPC):
*C03C 3/097* $^{(2006.01)}$     *C03C 21/00* $^{(2006.01)}$

(52) Cooperative Patent Classification (CPC):
**C03C 21/002; C03C 3/097**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **18.03.2022  KR 20220034255**

(71) Applicants:
• **Samsung Display Co., Ltd.
Yongin-si, Gyeonggi-do 17113 (KR)**
• **Kongju National University Industry-University
Cooperation Foundation
Gongju-si, Chungcheongnam-do 32588 (KR)**

(72) Inventors:
• **KIM, Seung
Giheung-gu, Yongin-si, Gyeonggi-do (KR)**
• **Chung, Woon Jin
602-202 Bundang-gu, Seongnam-si (KR)**
• **PARK, Kyeong Dae
Seobuk-gu, Cheonan-si, Chungcheongnam-do
(KR)**
• **KANG, Min Gyeong
Seobuk-gu, Cheonan-si, Chungcheongnam-do
(KR)**
• **Kim, Seung Ho
Giheung-gu, Yongin-si, Gyeonggi-do (KR)**
• **PARK, Seong Young
Seobuk-gu, Cheonan-si, Chungcheongnam-do
(KR)**
• **PARK, Cheol Min
Giheung-gu, Yongin-si, Gyeonggi-do (KR)**
• **SHON, Hui Yeon
Giheung-gu, Yongin-si, Gyeonggi-do (KR)**
• **SHIM, Gyu In
Giheung-gu, Yongin-si, Gyeonggi-do (KR)**
• **LEE, Jae Gil
Giheung-gu, Yongin-si, Gyeonggi-do (KR)**
• **JANG, Jin Won
Giheung-gu, Yongin-si, Gyeonggi-do (KR)**
• **JUNG, So Mi
Giheung-gu, Yongin-si, Gyeonggi-do (KR)**

(74) Representative: **Dr. Weitzel & Partner
Patent- und Rechtsanwälte mbB
Friedenstrasse 10
89522 Heidenheim (DE)**

(54) **GLASS COMPOSITION, GLASS ARTICLE PREPARED THEREFROM, AND DISPLAY DEVICE
INCLUDING THE GLASS ARTICLE**

(57)    A glass composition article including as a glass composition, wherein the glass composition includes about 60 to about 75 mole percent (mol%) of $SiO_2$, about 3 to about 10 mol% of $Al_2O_3$, about 3 to about 10 mol% of $Na_2O$, about 10 to about 25 mol% of $Li_2O$, 0 to about 1 mol% of $P_2O_5$, and about 1 to about 5 mol% of $ZrO_2$, wherein each amount is based on 100 mole percent total of the glass composition, wherein a thickness of the glass article is in a range of about 20 micrometers to about 100 micrometers, and wherein the glass composition satisfies Mathematical Expression 1:

Mathematical Expression 1

$$0.1 < (Al_2O_3)/(R_2O) < 0.5$$  expression 1

wherein $(R_2O)$ represents a total mole percent of $Na_2O$ and $Li_2O$ combined, and $(Al_2O_3)$ represents mole percent of $Al_2O_3$.

**FIG. 1**

**Description**

BACKGROUND

1. Technical Field

The present invention relates to a glass composition, a glass article prepared therefrom, and a display device.

2. Description of the Related Art

Glass articles are widely used in electronic devices including display devices, building materials, or the like. For example, glass articles are applied to substrates of flat panel display devices such as a liquid crystal display device (LCD), an organic light emitting display device (OLED), an electrophoretic display device, or the like. Glass articles are also applied to cover a window protecting a flat panel display device.

As the use of portable electronic devices such as smartphones and tablet personal computers (PCs) increases, glass articles applied to the portable electronic devices are also frequently exposed to external impacts and shock. Accordingly, the development of glass articles has focused on those glass articles that are capable of withstanding an external shock and that are thin for portability.

Recently, for convenience of a user, foldable display devices have been developed. The glass articles applied to a foldable display device preferably have a strength capable of withstanding an external shock and also have a small thickness to relieve bending stress when being folded. Accordingly, there is an ongoing need to improve the strength of thin glass articles, for example by changing a component ratio and/or a preparation process condition of a composition of the glass article.

SUMMARY

The present invention provides a glass composition having a particular composition ratio, a glass article prepared therefrom, and a display device including the glass article. The substance matter of the present invention is defined by the independent claims. The dependent claims describe preferred embodiments.

However, aspects and embodiments are not restricted to those set forth herein. The above and other aspects and embodiments will become more apparent to one of ordinary skill in the art by referencing the detailed description.

According to an embodiment of the present invention, a glass article includes a glass composition, wherein the glass composition includes:

about 60 mole percent (mol%) to about 75 mol% of $SiO_2$,
about 3 mol% to about 10 mol% of $Al_2O_3$,
about 3 mol% to 10 mol% of $Na_2O$,
about 10 to about 25 mol% of $Li_2O$,
0 mol% to about 1 mol% of $P_2O_5$, and
about 1 to about 5 mol% of $ZrO_2$,
wherein each amount is based on 100 mole percent total of the glass composition,
wherein a thickness of the glass article is in a range of about 20 micrometers ($\mu$m) to about 100 micrometers, and
wherein the glass composition satisfies Mathematical Expression 1:

$$\text{Mathematical Expression 1}$$

$$0.1 < Al_2O_3/R_2O < 0.5$$

wherein ($R_2O$) represents a total mole percent of $Na_2O$ and $Li_2O$ combined, and ($Al_2O_3$) represents mole percent of $Al_2O_3$.

In one or more embodiments, based on 100 mole percent total of the glass composition, the glass composition may include about 67.2 mol% of $SiO_2$, about 6.3 mol% of $Al_2O_3$, about 5.1 mol% of $Na_2O$, about 18.7 mol% of $Li_2O$, wherein a ratio of ($Al_2O_3$)/($R_2O$) is 0.27.

In one or more embodiments, the glass composition may further include 0 mol% to about 1 mol% of $K_2O$, based on 100 mole percent total of the glass composition.

In one or more embodiments, based on 100 mole percent total of the glass composition, the glass composition may include about 67.2 mol% of $SiO_2$, about 6.3 mol% of $Al_2O_3$, about 5.0 mol% of $Na_2O$, about 18.7 mol% of $Li_2O$, about 0.1 mol% of $K_2O$, wherein a ratio of $(Al_2O_3)/(R'_2O)$ is 0.26, and wherein $(R'_2O)$ represents a total mole percent of $Na_2O$, $Li_2O$, and $K_2O$ combined.

In one or more embodiments, a coefficient of thermal expansion (CTE) of the glass composition may be about $75 \times 10^{-7}$ $K^{-1}$ to about $85 \times 10^{-7}$ $K^{-1}$.

In one or more embodiments, a glass transition temperature $(T_g)$ of the glass article may be about 450°C to about 550°C.

In one or more embodiments, a density of the glass article may be about 2.4 grams per cubic centimeter $(g/cm^3)$ to about 2.6 $g/cm^3$.

In one or more embodiments, an elastic modulus of the glass article may be about 75 gigapascal (GPa) to about 85 GPa.

In one or more embodiments, a Poisson's ratio of the glass article may be about 0.3 to about 0.4.

In one or more embodiments, a hardness of the glass article may be about 5.5 GPa to about 6.5 GPa.

In one or more embodiments, a fracture toughness of the glass article may be about 1.0 megapascal square root meters $(MPa*m^{0.5})$ to about 1.5 $MPa*m^{0.5}$.

In one or more embodiments, a brittleness of the glass article may be about 4.5 $\mu m^{-0.5}$ to about 5.5 $\mu m^{-0.5}$.

According to one embodiment of the present invention, a glass composition comprises about 60 mol% to about 75 mol% of $SiO_2$, about 3 mol% to about 10 mol% of $Al_2O_3$, about 3 mol% to about 10 mol% of $Na_2O$, about 10 mol% to about 25 mol% of $Li_2O$, 0 mol% to about 1 mol% of $P_2O_5$, and about 1 mol% to about 5 mol% of $ZrO_2$, wherein each amount is based on 100 mole percent total of the glass composition, and wherein Mathematical Expression 1 is satisfied:

$$\text{Mathematical Expression 1}$$

$$0.1 < Al_2O_3/R_2O < 0.5$$

wherein $(R_2O)$ represents a total mole percent of $Na_2O$ and $Li_2O$ combined, and $(Al_2O_3)$ represents mole percent of $Al_2O_3$.

In one or more embodiments, based on 100 mole percent total of the glass composition, the glass composition may include about 67.2 mol% of $SiO_2$, about 6.3 mol% of $Al_2O_3$, about 5.1 mol% of $Na_2O$, about 18.7 mol% of $Li_2O$, and a ratio of $(Al_2O_3)/(R_2O)$ is 0.26.

In one or more embodiments, the glass composition may further comprise 0 mol% to about 1 mol% of $K_2O$, based on 100 mole percent total of the glass composition.

In one or more embodiments, based on 100 mole percent total of the glass composition, the glass composition may include about 67.2 mol% $SiO_2$, about 6.3 mol% of $Al_2O_3$, about 5.0 mol% of $Na_2O$, about 18.7 mol% of $Li_2O$, about 0.1 mol% of $K_2O$, wherein a ratio of $(Al_2O_3)/(R'_2O)$ is 0.26, and wherein $(R'_2O)$ represents a total mole percent of $Na_2O$, $Li_2O$, and $K_2O$ combined.

In one or more embodiments, a total amount of $Na_2O$ and $Li_2O$ may be about 20 mol% to about 25 mol%, based on 100 mole percent total of the glass composition.

According to one embodiment of the present invention, a display device includes a display panel including a plurality of pixels, a cover window disposed on the display panel, and an optically clear coupling layer disposed between the display panel and the cover window, wherein the cover window includes a glass composition, wherein the glass composition includes about 60 mol% to about 75 mol% of $SiO_2$, about 3 mol% to about 10 mol% of $Al_2O_3$, about 3 mol% to about 10 mol% of $Na_2O$, about 10 mol% to about 25 mol% of $Li_2O$, 0 mol% to about 1 mol% of $P_2O_5$, and about 1mol% to about 5 mol% of $ZrO_2$, wherein each amount is based on 100 mole percent total of the glass composition, wherein a thickness of the cover window is in a range of about 20 micrometers to about 100 micrometers, and wherein the glass composition satisfies Mathematical Expression 1:

$$\text{Mathematical Expression 1}$$

$$0.1 < Al_2O_3/R_2O < 0.5$$

wherein $(R_2O)$ represents a total mole percent of $Na_2O$ and $Li_2O$ combined, and $(Al_2O_3)$ represents mole percent of $Al_2O_3$. The cover window may be the glass article of the present invention, as described herein.

In one or more embodiments, in the cover window, the glass composition may further include 0 mol% to about 1 mol% of $K_2O$, based on 100 mole percent total of the glass composition.

In one or more embodiments, in the cover window, the glass composition may include a total amount of $Na_2O$ and $Li_2O$ from about 20 mol% to about 25 mol%, based on 100 mole percent total of the glass composition.

In a glass composition according to one or more embodiments, respective components may include particular composition ratios, and a glass article prepared from the glass composition may have an excellent mechanical strength, surface strength, and shock resistance properties while having flexibility. In particular, the glass article may have excellent flexibility and enough strength to be use in a foldable display device.

BRIEF DESCRIPTION OF THE DRAWINGS

These and/or other aspects and features will become more apparent and more readily appreciated from the following detailed description, taken in conjunction with the accompanying drawings, in which:

FIG. 1 is a perspective view of glass articles in accordance with one or more embodiments;
FIG. 2 is a perspective view according to one or more embodiments illustrating an unfolded state of a display device wherein a glass article is applied;
FIG. 3 is a perspective view illustrating a folded state of the display device of FIG. 2;
FIG. 4 is a cross-sectional view according to one or more embodiments showing a glass article that is applied as a cover window of a display device;
FIG. 5 is a cross-sectional view according to one or more embodiments of a glass article having a flat panel plate shape;
FIG. 6 is a graph illustrating a stress profile of the glass article according to one or more embodiments;
FIG. 7 is a flowchart according to one or more embodiments illustrating the steps S 1 to S6 of a process of preparing the glass article according to one or more embodiments; and
FIG. 8 is a flow chart of schematic diagrams showing steps S2 to S6 from the flow chart of FIG. 7.

DETAILED DESCRIPTION OF THE EMBODIMENTS

The present subject matter will now be described in further detail and with reference to the accompanying drawings, wherein one or more exemplary embodiments are shown. The subject matter may, however, be embodied in various different forms and should not be construed as being limited to the exemplary embodiments provided herein. Rather, these exemplary embodiments are provided so that this disclosure will be thorough and complete, and will filly convey the scope of the subject matter to those having ordinary skill in the art.

It will also be understood that when a layer is referred to as being "on" another layer or substrate, the layer may be directly on the other layer or substrate, or one or more intervening layers may also be present. In contrast, when an element is referred to as being "directly on" another element, there are no intervening elements present.

It will be understood that when an element is referred to as being related to another element such as being "coupled" or "connected" to another element, it can be directly coupled or connected to the other element or intervening elements may be present therebetween. In contrast, it should be understood that when an element is referred to as being related to another element such as being "directly coupled" or "directly connected" to another element, there are no intervening elements present. Other expressions that explain the relationship between elements, such as "between," "directly between," "adjacent to," or "directly adjacent to," should be construed in the same way.

The same reference numbers indicate the same components throughout the specification.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm 30\%$, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Each of the features of the various exemplary embodiments may be combined or combined with each other, in part or in whole, and technically various interlocking and driving are possible. Each exemplary embodiment may be implemented independently of each other or may be implemented together in an association.

Hereinafter, exemplary embodiments will be described in further detail and with reference to the accompanying drawings.

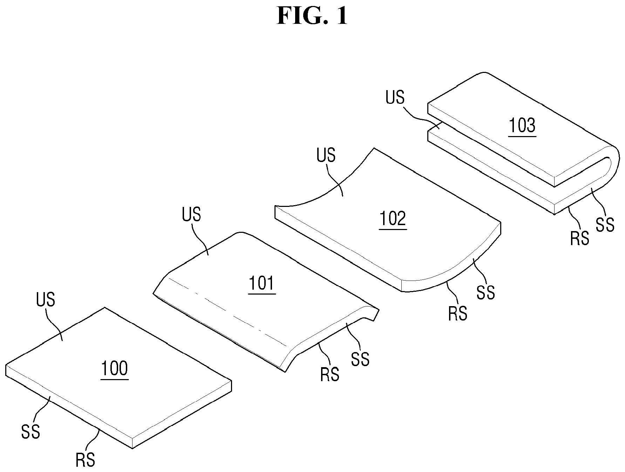

FIG. 1 is a perspective view of glass articles in accordance with various embodiments.

A glass article may be used as a cover window for protecting a display panel, as a substrate for a display panel, as a substrate for a touch panel, as an optical member such as a light guide plate, or the like, in electronic devices including displays, such as refrigerators and washing machines including display screens, as well as tablet personal computers (PCs), laptop computers, smartphones, electronic books, televisions, and PC monitors. The glass article may also be used as a cover glass of instrument dashboards of vehicles, a cover glass for solar cells, an interior building material, a window of buildings or houses, or the like.

Some glass articles desirably have a high strength. For example, a glass article for a window preferably has sufficient strength so as not to be easily damaged by an external impact or shock, while also having a small thickness (i.e., a thin article) to provide a high transmissivity and a lighter weight. A glass article with increased strength may be prepared by a method such as chemical strengthening (e.g., chemical tempering) and/or thermal strengthening (e.g., thermal tempering). Exemplary shapes of strengthened glasses are illustrated in FIG. 1.

Referring to FIG. 1, in one or more embodiments, a glass article 100 may be in a shape of a flat panel sheet or flat panel plate. In another embodiment, glass articles 101, 102, and 103 may have a three-dimensional shape including a curved or bent portion. For example, edges of a flat portion of the glass article may be curved (see '101'), or the glass article may be overall curved (see '102'), or the glass article may be folded (see '103'). Alternatively, the glass article 100 may have the shape of a flat panel sheet or flat panel plate, but may have flexibility and be folded, stretched, and/or rolled.

Each of the glass articles 100 to 103 may have a rectangular planar shape in plan view. However, each shape of embodiments of glass articles 100 to 103 is not limited thereto, and may have various shapes such as a rectangular shape with rounded corners, a square shape, a circular shape, or an elliptical shape. In the following exemplary embodiments, it will be described by way of example that each of the glass articles 100 to 103 is a flat panel plate having a rectangular planar shape in plan view, but embodiments are not limited thereto.

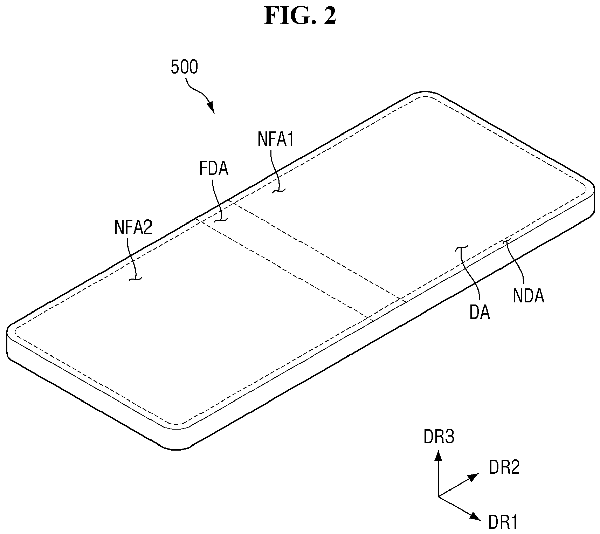

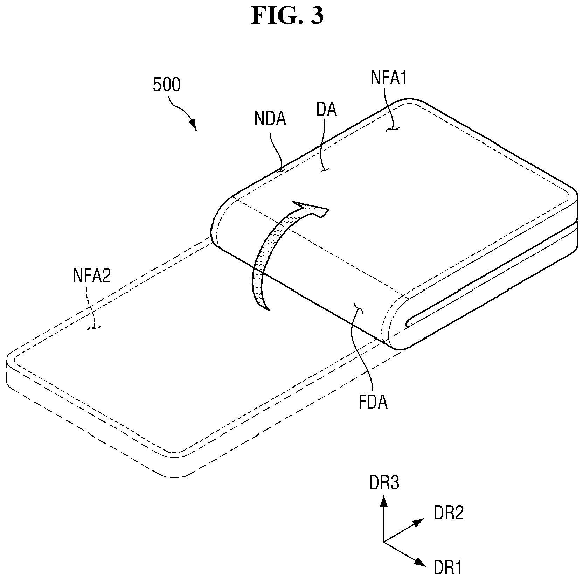

FIG. 2 is a perspective view illustrating an unfolded state of a display device to which a glass article according to one or more embodiments is applied. FIG. 3 is a perspective view illustrating a folded state of the display device of FIG. 2.

Referring to FIGS. 2 and 3, a display device 500 according to one or more embodiments may be a foldable display device. As described herein, in the display device 500, the glass article 100 of FIG. 1 may be applied as a cover window, and the glass article 100 may have flexibility and be folded.

In FIGS. 2 and 3, a first direction DR1 may be a direction parallel to one side of the display device 500 in plan view, and may be, for example, a transverse direction of the display device 500. A second direction DR2 is a direction parallel to the other side of the display device 500 in contact with one side of the display device 500 in plan view, and may be a longitudinal direction of the display device 500. A third direction DR3 may be a thickness direction of the display device 500.

In one or more embodiments, the display device 500 may have a rectangular planar shape in plan view. The display device 500 may have a rectangular planar shape with vertical corners or a rectangular planar shape with rounded corners in plan view. The display device 500 may include two shorter sides disposed in the first direction DR1 and two longer sides disposed in the second direction DR2 in plan view. As noted before, a third direction DR3 may be a thickness direction of the display device 500.

The display device 500 may include a display area DA and a non-display area NDA. In plan view, a shape of the display area DA may correspond to the shape of the display device 500. For example, when the display device 500 has a rectangular planar shape in plan view, the display area DA may also have a rectangular planar shape.

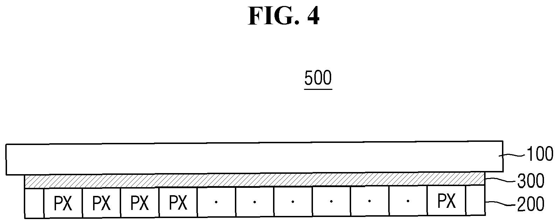

The display area DA may be an area displaying an image by including a plurality of pixels (PX in FIG. 4). The plurality of pixels PX may be arranged in a matrix direction. The plurality of pixels may have a rectangular planar shape, a rhombic shape, an elliptic shape, circular shape, or a square shape in plan view, but are not limited thereto. For example, the plurality of pixels PX may have a quadrangular shape other than the rectangular planar shape, the rhombic shape, or the square shape. For example, the plurality of pixels may have a polygonal shape other than a quadrangular shape, a circular shape, or an elliptical shape in plan view.

The non-display area NDA may be an area that does not display an image because it does not include pixels. The non-display area NDA may be disposed around the perimeter of the display area DA, as shown in FIG. 2. The non-display area NDA may be disposed to surround the perimeter of the display area DA, but is not limited thereto. The perimeter of the display area DA may be partially surrounded by the non-display area NDA.

In one or more embodiments, the display device 500 may be maintained in both a folded state and an unfolded state. The display device 500 may be folded in an in-folding manner in which the display area DA is disposed inside the folded display device 500 as illustrated in FIG. 3. When the display device 500 is folded in the in-folding manner, the upper or top surfaces of the display device 500 may be disposed to face each other. As another example, the display device 500 may be folded in an out-folding manner in which the display area DA is disposed outside of the folded display device 500. When the display device 500 is folded in the out-folding manner, the lower or bottom surfaces of the display device 500 may be disposed to face each other.

In one or more embodiments, the display device 500 may be a foldable device. The term "foldable device" as used herein refers to a device that may be folded, and is used as the meaning including not only a folded device, but also a device that may have both a folded state and an unfolded state, and wherein the foldable device may be transitioned from a folded state to an unfolded state, and back again from an unfolded state to a folded state. In addition, folding typically includes folding at an angle of about 180° relative to the second direction D2, but is not limited thereto, and when a folding angle exceeds 180° or is less than 180°, for example, 90° or greater and less than 180°, or 120° or greater and less than 180°, it may be understood that the display device is in a folded state. In addition, when the display device is in a bent state out of an unfolded state even though it is not completely folded, the display device may be referred to as being in the folded state. For example, even though the display device is bent at an angle of 90° or less, as long as the display device has a maximum folding angle that is 90° or greater, it may be expressed that the display device is in the folded state in order to be distinguished from the unfolded state. A radius of curvature of the display device when being folded may be about 5 millimeters (mm) or less, and may be preferably in the range of about 1 mm to about 2 mm, or may be about 1.5 mm, but is not limited thereto.

In one or more embodiments, the display device 500 may include a folding area FDA, a first non-folding area NFA1, and a second non-folding area NFA2. The folding area FDA may be an area in which the display device 500 is folded, and the first non-folding area NFA1 and the second non-folding area NFA2 each may be areas in which the display device 500 is not folded.

The first non-folding area NFA1 may be disposed on one side, for example, the upper portion of the folding area FDA. The second non-folding area NFA2 may be disposed on the other portion, for example, the lower portion of the folding area FDA. The folding area FDA may be an area curved with a predetermined curvature.

In one or more embodiments, the folding area FDA of the display device 500 may be determined at a specific position. The number of folding areas FDA determined at a specific position in the display device 500 may be one or two or more. In another embodiment, a position of the folding area FDA is not specified in the display device 500, and may be freely set in various areas.

In one or more embodiments, the display device 500 may be folded in the second direction DR2. Accordingly, a length of the display device 500 in the second direction DR2 may be reduced by approximately half when the display device 500 is completely folded, and thus, a user may conveniently carry the display device 500 in a pocket, purse, backpack, briefcase, or other conveyance.

In one or more embodiments, a direction in which the display device 500 is folded is not limited to the second direction DR2. For example, the display device 500 may be folded in the first direction DR1. In this case, a length of the display device 500 in the first direction DR1 may be reduced by approximately half when the display device 500 is completely folded.

It has been illustrated in FIGS. 2 and 3 that each of the display area DA and the non-display area NDA overlaps the folding area FDA, the first non-folding area NFA1, and the second non-folding area NFA2, but embodiments are not limited thereto. For example, each of the display area DA and the non-display area NDA may overlap at least one of the folding area FDA, the first non-folding area NFA1, and/or the second non-folding area NFA2.

FIG. 4 is a cross-sectional view illustrating an example in which the glass article according to one or more embodiments is applied as a cover window of the display device 500.

Referring to FIG. 4, the display device 500 may include a display panel 200, the glass article 100 disposed on the display panel 200 and serving as a cover window, and an optically clear coupling (i.e., bonding) layer 300 disposed between the display panel 200 and the glass article 100, and coupling or bonding the display panel 200 and the glass article 100 to each other.

The display panel 200 may be, for example, a self-luminous display panel such as an organic light emitting display panel (OLED), an inorganic electroluminescent (EL) light emitting display panel, a quantum dot light emitting display panel (QED), a micro LED display panel (micro-LED), a nano LED display panel (nano-LED), a plasma display panel

(PDP), a field emission display panel (FED), or a cathode ray tube (CRT) display panel, or may be a light-receiving display panel such as a liquid crystal display panel (LCD) and an electrophoretic display panel (EPD).

The display panel 200 may include a plurality of pixels PX, and may display an image using light emitted from each pixel PX. The display device 500 may further include a touch member (not illustrated). In one or more embodiments, the touch member may be internalized in the display panel 200. For example, the touch member may be directly formed on a display member of the display panel 200, such that the display panel 200 itself may perform a touch function. In another embodiment, the touch member may be prepared separately from the display panel 200 and then attached to an upper surface of the display panel 200 by the optically clear coupling layer 300.

The glass article 100 protecting the display panel 200 is disposed on or above the display panel 200. The glass article 100 has a larger size than the display panel 200, such that side surfaces thereof may protrude further out than side surfaces of the display panel 200, but embodiments are not limited thereto. The display device 500 may further include a printing layer (not illustrated) disposed on at least one surface of the glass article 100 at an edge portion of the glass article 100. The printing layer may prevent a bezel area or region of the display device 500 from being viewed externally, and may selectively or optionally perform a decorative function in some cases.

The optically clear coupling layer 300 is disposed between the display panel 200 and the glass article 100. The optically clear coupling layer 300 serves to fix or bond the glass article 100 onto the display panel 200. The optically clear coupling layer 300 may include an optical clear adhesive (OCA), an optical clear resin (OCR), or the like.

Hereinafter, the glass article 100 strengthened as described above will be described in further detail.

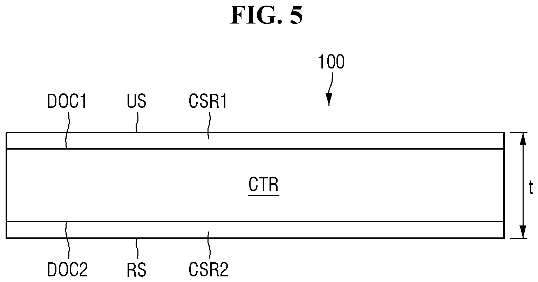

FIG. 5 is a cross-sectional view of a glass article having a flat panel plate shape according to one or more embodiments.

Referring to FIG. 5, the glass article 100 may include a first surface US, a second surface RS, and side surfaces. In the glass article 100 having the flat panel plate shape, the first surface US and the second surface RS are main surfaces having a large surface area, and the side surfaces are outer surfaces connecting the first surface US and the second surface RS to each other.

The first surface US and the second surface RS oppose each other in the thickness direction. When the glass article 100 serves to transmit light like a cover window of a display, the light may mainly enter any one of the first surface US and the second surface RS and be then transmitted through the other of the first surface US and the second surface RS.

A thickness t of the glass article 100 may be defined as a distance between the first surface US and the second surface RS. The thickness t of the glass article 100 may be in the range of about 20 $\mu$m to about 100 $\mu$m, but is not limited thereto. In one or more embodiments, the thickness t of the glass article 100 may be about 80 $\mu$m or less. In another embodiment, the thickness t of the glass article 100 may be about 75 $\mu$m or less. In still another embodiment, the thickness t of the glass article 100 may be about 70 $\mu$m or less. In still another embodiment, the thickness t of the glass article 100 may be about 60 $\mu$m or less. In still another embodiment, the thickness t of the glass article 100 may be about 65 $\mu$m or less. In still another embodiment, the thickness t of the glass article 100 may be about 50 $\mu$m or less. In still another embodiment, the thickness t of the glass article 100 may be about 30 $\mu$m or less. In some specific embodiments, the thickness t of the glass article 100 may be in the range of about 20 $\mu$m to about 80 $\mu$m, about 20 $\mu$m to about 70 $\mu$m, about 20 $\mu$m to about 60 $\mu$m, about 20 $\mu$m to about 50 $\mu$m, or may have a value of about 30 $\mu$m. The glass article 100 may have a uniform thickness t, but is not limited thereto, and may have a different thickness t for each region.

The glass article 100 may be strengthened or tempered to have a predetermined stress profile therein. The occurrence of cracks, propagation of cracks, damage, and the like, due to an external impact and shock are better prevented in the strengthened glass article 100 than in the glass article 100 before being strengthened. The glass article 100 strengthened through a strengthening process may have various stresses for each region. For example, compressive regions CSR1 and CSR2 in which compressive stresses act, may be disposed in the vicinity of surfaces of the glass article 100, that is, in the vicinity of the first surface US and the second surface RS, and a tensile region CTR in which a tensile stress acts may be disposed inside the glass article 100. Stress values of boundaries DOC1 and DOC2 between the compressive regions CSR1 and CSR2 and the tensile region CTR may be 0. A stress value of the compressive stress in one compressive region CSR1 or CSR2 may change depending on a position (i.e., a depth of a point from the respective surfaces). In addition, the tensile region CTR may have different stress values depending on a depth from the surfaces US or RS.

Positions of the compressive regions CSR1 and CSR2, stress profiles within the compressive regions CSR1 and CSR2, compressive energy of the compressive regions CSR1 and CSR2, tensile energy of the tensile region CTR, or the like, within the glass article 100 may have a significant influence on mechanical properties such as a surface strength of the glass article 100.

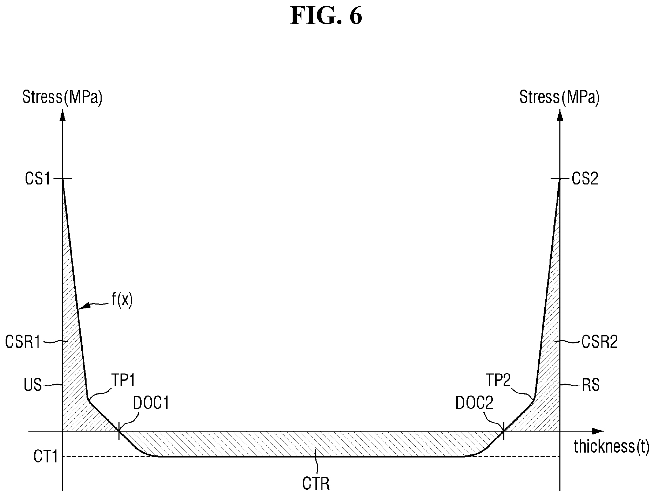

FIG. 6 is a graph illustrating a stress profile of the glass article 100 according to one or more embodiments. In the graph of FIG. 6, an x axis indicates the thickness (t) direction of the glass article 100, and y axis indicates stress. In FIG. 6, the compressive stress is expressed as a positive value and the tensile stress is expressed as a negative value. As used herein, a magnitude of the compressive/tensile stress refers to a magnitude of an absolute value without regard to a sign of a value of the compressive/tensile stress.

Referring to FIGS. 5 and 6, the glass article 100 includes a first compressive region CSR1 extending from the first surface US to a first compressive depth DOC1 and a second compressive region CSR2 extending from the second surface RS to a second compressive depth DOC2. The tensile region CTR is disposed between the first compressive depth DOC1 and the second compressive depth DOC2. The overall stress profile in the glass article 100 may have a relationship in which the regions of both surfaces US and RS are symmetrical to each other with respect to the center in the thickness t direction. Although not illustrated in FIG. 6, compressive and tensile regions may be disposed between opposing side surfaces of the glass article 100 in a similar manner.

The first compressive region CSR1 and the second compressive region CSR2 serve to resist an external impact or shock to mitigate the occurrence of cracks in the glass article 100 or damage to the glass article 100. As maximum compressive stresses CS1 and CS2 of the first compressive region CSR1 and the second compressive region CSR2 increase, a strength of the glass article 100 generally increases. Since the external impact or shock is normally transferred through the surfaces US and RS of the glass article 100, it is advantageous in terms of durability to have the maximum compressive stresses CS 1 and CS2 on the surfaces of the glass article 100. From such a point of view, the compressive stress of the first compressive region CSR1 and the second compressive region CSR2 is greatest at the surfaces of the glass article and tends to decrease toward the inside of the glass article.

The first compressive depth DOC1 and the second compressive depth DOC2 prevent cracks or grooves formed in the first surface US and the second surface RS from propagating into the tensile region CTR inside the glass article 100. As the first compressive depth DOC1 and the second compressive depth DOC2 become greater, the propagation of the cracks and the like may be better prevented. Points corresponding to the first compressive depth DOC1 and the second compressive depth DOC2 correspond to the boundaries between the compressive regions CSR1 and CSR2 and the tensile region CTR, and have a stress value of 0.

Throughout the glass article 100, the tensile stress of the tensile region CTR may be balanced with the compressive stress of the compressive regions CSR1 and CSR2. That is, the sum (i.e., compressive energy) of the compressive stresses and the sum (i.e., tensile energy) of the tensile stresses in the glass article 100 may be the same as each other. Stress energy accumulated in one region having a constant width in the thickness t direction in the glass article 100 may be calculated as a value obtained by integrating a stress profile. When the stress profile in the glass article 100 having a thickness t is expressed as a function f(x), Equation 1 may be satisfied.

$$\text{Equation 1}$$

$$\int_0^t f(x)\,dx = 0$$

As a magnitude of the tensile stress inside the glass article 100 increases, there is a risk that fragments will be more violently released and crushing will occur from the inside of the glass article 100, when the glass article 100 is broken. A maximum tensile stress that satisfies a fragility criterion of the glass article 100 may satisfy Equation 2, but is not limited thereto.

Equation 2

$$CT_1 \leq -38.7 \times \ln(t) + 48.2$$

wherein CT1 is maximum tensile stress.

In some embodiments, a maximum tensile stress CT1 may be about 100 megapascal (MPa) or less, or about 85 MPa or less. Meanwhile, it may be preferable in improving mechanical properties, such as a strength, that the maximum tensile stress CT1 is about 75 MPa or greater. In one or more embodiments, the maximum tensile stress CT1 may be about 75 MPa or greater and about 85 MPa or less, but is not limited thereto.

The maximum tensile stress CT1 of the glass article 100 may be positioned at a central portion of the glass article 100 in the thickness t direction. For example, the maximum tensile stress CT1 of the glass article 100 may be positioned at a depth in the range of 0.4t to 0.6t or in the range of 0.45t to 0.55t or be positioned at a depth of about 0.5t.

Meanwhile, it is preferable that the compressive stresses and the compressive depths DOC1 and DOC2 are great in order to increase a strength of the glass article 100, but as the compressive energy increases, the tensile energy also increases, such that the maximum tensile stress CT1 may also increase. It is preferable to adjust the stress profile so that the maximum compressive stresses CS1 and CS2 and the compressive depths DOC1 and DOC2 are greater and the compressive energy is smaller in order to satisfy the fragility criterion while having a high strength. To this end, the glass article 100 may be prepared by a glass composition including specific components in a predetermined amount. According to a composition ratio of the components included in the glass composition, the prepared glass article 100 may have an excellent strength and, at the same time, may have flexible properties and physical properties so as to be able to be applied to a foldable display device.

According to one or more aspects, the glass composition forming the glass article 100 includes about 60 mol% to about 75 mol% of $SiO_2$, about 3 mol% to about 10 mol% of $Al_2O_3$, about 3 mol% to about 10 mol% of $Na_2O$, about 10 mol% to about 25 mol% of $Li_2O$, 0 mol% to about 1 mol% of $P_2O_5$, and about 1 mol% to about 5 mol% of $ZrO_2$, wherein each amount is based on 100 mole percent total of the glass composition. Here, a "content of any component is 0 mol%" means that the glass component does not substantially contain the corresponding component. A phrase "glass composition substantially does not contain a specific component" means that the specific composition is not intentionally contained in a raw material or the like, and includes, for example, a case where the glass composition unavoidably contains a trace (e.g., 0.1 mol% or less) of impurities.

Respective component of the glass composition will be described in further detail below.

Without wishing to be bound to theory, $SiO_2$ may serve to constitute a skeleton of the glass, improve chemical durability, and reduce the occurrence of cracks when a scratch (indentation) occurs on a glass surface. $SiO_2$ may be a network former oxide forming a network of the glass, and the glass article 100 prepared to include $SiO_2$ may have a decreased coefficient of thermal expansion and an improved mechanical strength. In order to sufficiently perform the role as described above, a content of $SiO_2$ is about 60 mol% or greater, based on 100 mole percent total of the glass composition. In order to exhibit sufficient meltability, a content of $SiO_2$ in the glass composition is about 75 mol% or less, based on 100 mole percent total of the glass composition.

Without wishing to be bound to theory, $Al_2O_3$ serves to improve friability of the glass. In other words, $Al_2O_3$ may serve to allow a smaller number of fragments to occur when the glass breaks. $Al_2O_3$ may be an intermediate oxide forming a bond with $SiO_2$ forming a network structure. In addition, $Al_2O_3$ may act as an active component improving ion exchange performance at the time of chemical strengthening and increasing a surface compressive stress after the chemical strengthening. When a content of $Al_2O_3$ is about 3 mol% or greater, based on 100 mole percent total of the glass composition, $Al_2O_3$ may effectively perform the function as described above. Meanwhile, in order to maintain acid resistance and meltability of the glass, it is preferable that the content of $Al_2O_3$ is about 10 mol% or less, based on 100 mole percent total of the glass composition.

Without wishing to be bound to theory, $Na_2O$ serves to form a surface compressive stress by ion exchange and improves meltability of the glass. $Na_2O$ may form non-bridging oxygen in a $SiO_2$ network structure by forming an ionic bond with oxygen of $SiO_2$ forming the network structure. An increase in the non-bridging oxygen may improve flexibility of the network structure, and the glass article 100 may have physical properties that it is applicable to the foldable display device. It is preferable in effectively performing the role as described above that a content of $Na_2O$ is about 3 mol% or greater, based on 100 mole percent total of the glass composition. However, in terms of acid resistance of the glass article 100, it is preferable that the content of $Na_2O$ is about 10 mol% or less, based on 100 mole percent total of the glass composition.

Without wishing to be bound to theory, $Li_2O$ serves to form a surface compressive stress by ion exchange, and improves meltability of the glass, similar to $Na_2O$ described above. $Li_2O$ may form non-bridging oxygen in the $SiO_2$ network structure by forming an ionic bond with oxygen of $SiO_2$ forming the network structure. An increase in the non-bridging oxygen may improve flexibility and a shock absorption function of the network structure, and the glass article 100 may have physical properties that it is applicable to the foldable display device. It is preferable in effectively performing the role as described above that a content of $Li_2O$ is about 10 mol% or greater, based on 100 mole percent total of the glass composition. However, in terms of heat resistance of the glass article 100, it is preferable that the content of $Li_2O$ is about 25 mol% or less, based on 100 mole percent total of the glass composition.

Without wishing to be bound to theory, $ZrO_2$ may improve transmissivity and a surface strength of the glass, and increases resistance to surface crack expansion. $ZrO_2$ may be an intermediate oxide forming a bond with $SiO_2$ forming a network structure. $ZrO_2$ is bonded to a portion where a bond is broken by $Li_2O$ and $Na_2O$ in the $SiO_2$ network structure to increase fracture toughness of the glass and increase a repulsive force against bending. $ZrO_2$ may meaningfully perform the function as described above when a content thereof is about 1 mol% or greater, based on 100 mole percent total of the glass composition. However, in terms of flexibility of the glass article 100, it is preferable that the content of $ZrO_2$ is about 5 mol% or less, based on 100 mole percent total of the glass composition.

Without wishing to be bound to theory, $P_2O_5$ improves ion exchange performance and chipping resistance. $P_2O_5$ may also be a network former oxide forming a network structure together with $SiO_2$. $P_2O_5$ may form a chain structure similar to that of a polymer to have excellent ion mobility, and thus, may absorb a shock while positions of atoms are changed at the time of the shock. $P_2O_5$ may be omitted (0 mol%), but may meaningfully perform the function as described above when a content thereof is about 0.1 mol% or greater, based on 100 mole percent total of the glass composition. It is preferable that $P_2O_5$ has a content of about 1 mol% or less, based on 100 mole percent total of the glass composition, in terms of chemical resistance of the glass article.

According to one or more aspects, the glass composition satisfies Mathematical Expression 1:

## Mathematical Expression 1

$$0.1 < Al_2O_3/R_2O < 0.5$$

wherein, in Mathematical Expression 1,

($R_2O$) represents a total mole percent of $Na_2O$ and $Li_2O$ combined, and
($Al_2O_3$) represents mole percent of $Al_2O_3$.

In other words, in Mathematical Expression 1, R may be Na or Li. In other embodiments, R may be Na, Li, or K.

As described herein, the glass article 100 prepared by the glass composition according to one or more embodiments may have properties and physical properties that are applicable to the foldable display device. For example, the glass article 100 may have a flexible property to be able to be folded and unfolded, and may have impact resistance and chemical resistance properties that are sufficient for use as the cover window of the display device 500. In a network structure formed by $SiO_2$ and $Al_2O_3$ included in the glass composition, $Na_2O$ and $Li_2O$ are added, such that a network structure having flexibility may be formed. By the addition of $Na_2O$ and $Li_2O$, Na ions or Li ions form ionic bonds with oxygen between bonds forming the network structure, for example, inter-$SiO_2$ bonds, such that the non-bridging oxygen may increase. The increase in the non-bridging oxygen in the network structure means that the bond of the network structure is broken or becomes an open state, and the network structure of the glass may have greater flexibility. The glass composition may include $Na_2O$ in an amount of about 3 mol% or greater and $Li_2O$ in an amount of about 10 mol% or greater so that the prepared glass article 100 may have sufficient flexibility.

The glass composition includes relatively greater amounts of $Na_2O$ and $Li_2O$, and may thus have a lower mechanical strength. The glass composition includes $Al_2O_3$ in order to offset for the lower mechanical strength, and a ratio of the molar content of $Al_2O_3$ to the molar content of $R_2O$ (the sum of the molar contents of $Na_2O$ and $Li_2O$) is adjusted in the range of 0.1 to 0.5 according to Mathematical Expression 1, such that the mechanical strength may be added to the network structure. In the glass composition, the ratio of the molar content of $Al_2O_3$ to the molar content of $R_2O$ (the sum of the molar contents of $Na_2O$ and $Li_2O$) or an "R ratio" is in the range of 0.1 to 0.5.

When the ratio (R ratio) of the molar content of $Al_2O_3$ to the molar content of $R_2O$ (the sum of the molar contents of $Na_2O$ and $Li_2O$) included in the glass composition is 0.1 or greater, the molar contents of $Na_2O$ and $Li_2O$ are increased, and the increased $Na_2O$ and $Li_2O$ may break the network structure of $SiO_2$ to increase an interatomic distance in the network structure. Accordingly, extra space may be formed in the network structure of $SiO_2$, such that flexibility and shock absorption properties may be improved.

On the other hand, when the ratio (R ratio) of the molar content of $Al_2O_3$ to the molar content of $R_2O$ (the sum of the molar contents of $Na_2O$ and $Li_2O$) included in the glass composition becomes larger, portions where $Na_2O$ and/or $Li_2O$ break the network structure of $SiO_2$ may increase, and chemical durability of the glass may deteriorate. Accordingly, it is preferable that the ratio (R ratio) of the molar content of $Al_2O_3$ to the molar content of $R_2O$ (the sum of the molar

contents of $Na_2O$ and $Li_2O$) is 0.5 or less in terms of chemical durability of the glass article.

When the ratio (R ratio) of the molar content of $Al_2O_3$ to the molar content of $R_2O$ (the sum of the molar contents of $Na_2O$ and $Li_2O$) included in the glass composition has a value between 0.1 and 0.5, the flexibility, strength, and shock absorption properties of the glass article 100 may be improved.

In one or more embodiments, the glass composition may include about 67.2 mol% of $SiO_2$, about 6.3 mol% of $Al_2O_3$, about 5.1 mol% of $Na_2O$, and about 18.7 mol% of $Li_2O$, wherein each amount is based on 100 mole percent total of the glass composition, and wherein a ratio of $(Al_2O_3)/(R_2O)$ is 0.26 according to Mathematical Expression 1.

The glass composition may further include additional components such as one or more of $Y_2O_3$, $La_2O_3$, $Nb_2O_5$, $Ta_2O_5$, $Gd_2O_3$, or a combination thereof, if desired, in addition to the components mentioned above. In addition, the glass composition may further include traces of $Sb_2O_3$, $CeO_2$, and/or $As_2O_3$ as clarifiers.

Meanwhile, the glass composition may further include $K_2O$ to improve bending reliability of the glass article. $K_2O$ may replace Na with K to increase a compressive stress of the glass. Accordingly, $K_2O$ may contribute to realizing the flexible glass article 100 by improving folding reliability and the bending reliability of the glass article. $K_2O$ may be omitted (0 mol%), but may meaningfully perform the function as described above when a content thereof is about 0.1 mol% or greater. However, in terms of meltability of the glass article 100, it may be preferable that the content of $K_2O$ is about 1 mol% or less.

When the glass composition includes $K_2O$, in Mathematical Expression 1 of the glass composition, R may further include K. That is, the molar content of $R_2O$ in the total weight of the glass composition may be the sum of the molar content of $Na_2O$, the molar content of $Li_2O$, and the molar content of $K_2O$. In other aspects, $R'_2O$ represents a total mole percent of $Na_2O$, $Li_2O$, and $K_2O$ combined, wherein $R'_2O$ may be used interchangeably with $R_2O$ to satisfy Mathematical Expression 1. In one or more embodiments, a total amount of $Na_2O$, $Li_2O$, and $K_2O$ in the glass composition may be in the range of about 20 mol% to about 25 mol%, based on 100 mole percent total of the glass composition. In one or more embodiments, the glass composition may include about 67.2 mol% of $SiO_2$, about 6.3 mol% of $Al_2O_3$, about 5.0 mol% of $Na_2O$, about 18.7 mol% of $Li_2O$, and about 0.1 mol% of $K_2O$, and a ratio of $(Al_2O_3)/(R'_2O)$ is 0.26, wherein $(R'_2O)$ represents a total mole percent of $Na_2O$, $Li_2O$, and $K_2O$ combined.

The glass composition having the above-described composition may be formed into a sheet glass shape by various methods known in the art. When the glass composition is formed into the sheet glass shape, the glass composition in the sheet glass shape may be further processed to be prepared as the glass article 100 applicable to the display device 500. However, the present disclosure is not limited thereto, and the glass composition is not formed into the sheet glass shape, and may be directly formed into the glass article 100 applicable to an article without an additional forming process.

Hereinafter, a process in which the glass composition is formed into the sheet glass shape and the glass is processed into the glass article 100 will be described in further detail, but embodiments are not limited thereto.

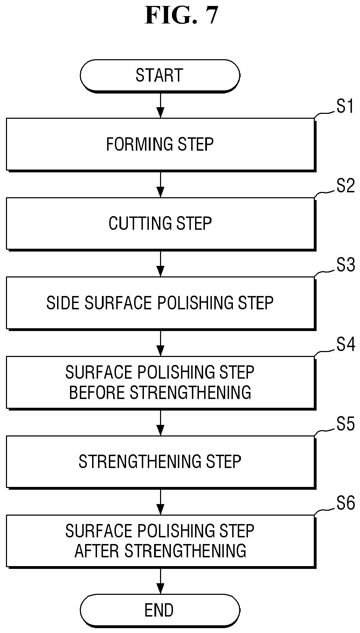

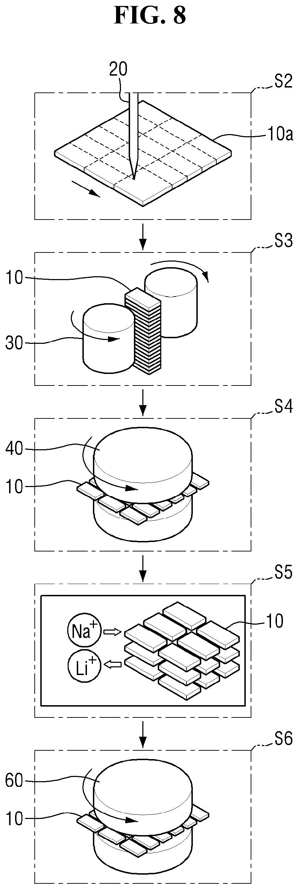

FIG. 7 is a flowchart illustrating each step of a process of preparing the glass article according to one or more embodiments. FIG. 8 is a flowchart of schematic diagrams illustrating a cutting step S2 to a surface polishing step S8 after strengthening in FIG. 7.

Referring to FIGS. 7 and 8, a method of preparing the glass article 100 may include a forming step (S1), a cutting step (S2), a side surface polishing step (S3), a surface polishing step before strengthening (S4), a strengthening step (S5), and a surface polishing step after strengthening (S6), but embodiments are not limited thereto.

The forming step (S1) may include a step of preparing the glass composition and a step of forming the glass composition. The glass composition may have the composition and the components as described herein. A detailed description of the glass composition will be omitted. The glass composition may be formed into the sheet glass shape by a method such as a float process, a fusion draw process, or a slot draw process.

A glass formed into a flat panel plate shape may be cut through the cutting step (S2). The glass formed into the flat panel plate shape may have a different size than the final glass article 100. For example, glass forming may be performed in a state of a large-area substrate as a mother substrate 10a including a plurality of glass articles, and the mother substrate 10a may be cut into a plurality of glass cells 10 to prepare the plurality of glass articles. For example, even though the final glass article 100 has a size of about 15.24 centimeters (i.e., about 6 inches), when the glass is formed in a size several to hundreds of times the size of the final glass article 100, for example, 304.8 cm (120 inches), and then cut, twenty glasses formed in the flat panel plate shape may be obtained at once. In this case, process efficiency may be improved as compared with a case of separately forming individual glass articles. In addition, even though a glass corresponding to a size of one glass article is formed, when the final glass article has various planar shapes, the glass may be prepared in a desired shape through a cutting process.

The cutting of the glass 10a may be performed using a cutting knife 20, a cutting wheel, a laser, or the like.

The cutting step (S2) of the glass may be performed before the strengthening step (S5) of the glass. The glass in a mother substrate 10a unit may be strengthened at once and then cut to a size of the final glass article, but in this case, cut surfaces (e.g., side surfaces of the glass) may be in a non-strengthened state, and thus, it may be preferable to first complete the cutting of the glass and then perform the strengthening step (S5). Accordingly, the strengthening step S5 may be performed after cutting is completed.

A polishing step before strengthening may be performed between the cutting step (S2) of the glass and the strengthening step (S5) of the glass. The polishing step may include the side surface polishing step (S3) and the surface polishing step before strengthening (S4). In one or more embodiments, the side surface polishing step (S3) is first performed and the surface polishing step before strengthening (S4) is then performed, but this order may also be reversed.

The side surface polishing step (S3) is a step of polishing side surfaces of the cut glass 10. In the side surface polishing step (S3), the side surfaces of the glass 10 are polished to allow the side surfaces of the glass cells 10 to have smooth surfaces. In addition, the respective side surfaces of the glass cells 10 may have uniform surfaces through the side surface polishing step (S3). More specifically, the cut glass cells 10 may include one or more cut surfaces. Two of four side surfaces of some cut glass cells 10 may be cut surfaces. Three of four side surfaces of some other cut glass cells 10 may be cut surfaces. All of four side surfaces of some other cut glass cells 10 may be cut surfaces. The surface roughness or the like may be different from each other when the side surface is a cut surface and when the side surface is an uncut surface. In addition, the cut surfaces may have a different surface roughness. Accordingly, by polishing the respective side surfaces through the side surface polishing step (S3), the respective side surfaces may have a uniform surface roughness or the like. Furthermore, when there is a small crack on the side surface, the small crack may be removed through the side surface polishing step (S3).

The side surface polishing step (S3) may be performed concurrently or simultaneously on a plurality of cut glass cells 10. That is, in a state in which the plurality of cut glass cells 10 are stacked, the stacked glass cells 10 may be polished simultaneously.

The side surface polishing step (S3) may be performed by a mechanical polishing method and/or a chemical mechanical polishing method using a polishing device 30. In one or more embodiments, two opposing side surfaces of the cut glass cells 10 may be polished simultaneously, and then, the other two opposing side surfaces of the cut glass cells 10 may be polished simultaneously, but embodiments are not limited thereto.

The surface polishing step (S4) before strengthening may be performed in order to allow each glass cell 10 to have a uniform surface. The surface polishing step before strengthening (S4) may be performed for each cut glass cell 10, but when a chemical mechanical polishing device 40 is sufficiently greater than the glass cells 10, a plurality of glass cells 10 may be horizontally arranged, and surfaces of the plurality of glass cells 10 may then be polished simultaneously.

The surface polishing step (S4) before strengthening may be performed by a chemical mechanical polishing method. Specifically, a first surface and a second surface of the cut glass cells 10 are polished using the chemical mechanical polishing device 40 and a polishing slurry. The first surface and the second surface may be polished simultaneously or any one of the first surface and the second surface may be first polished and the other of the first surface and the second surface may then be polished.

After the surface polishing step (S4) before strengthening, the strengthening step (S5) is performed. The strengthening step (S5) may be performed by chemical strengthening and/or thermal strengthening. When the glass cell 10 has a small thickness of about 2 mm or less, and furthermore, about 0.75 mm or less, a chemical strengthening method may be suitably applied in order to precisely control a stress profile.

After the strengthening step (S5), the surface polishing step after strengthening (S6) may be optionally further performed. The surface polishing step after strengthening (S6) may serve to remove fine cracks on the surface of the strengthened glass cell 10 and control compressive stresses of the first surface and the second surface of the strengthened glass cell 10. For example, a floating method, which is one of methods of preparing a sheet glass, is performed in a manner of pouring a glass composition into a tin bath, in this case, a surface in contact with the tin bath and a surface that is not in contact with the tin bath may have different compositions. Accordingly, after the strengthening step (S5) of the glass cell 10, a deviation of a compressive stress between the surface in contact with the tin bath and a surface that is not in contact with the tin bath may occur, but by removing the surface of the glass cell 10 to an appropriate thickness by polishing, the deviation of the compressive stress between the surface in contact with the tin bath and a surface that is not in contact with the tin bath may be decreased.

The surface polishing step after strengthening (S6) may be performed by a chemical mechanical polishing method. Specifically, a first surface and a second surface of the strengthened glass cell 10, which is a glass cell 10 to be processed, are polished using the chemical mechanical polishing device 60 and a polishing slurry. A polishing thickness may be adjusted, for example, in the range of about 100 nm to about 1,000 nm, but is not limited thereto. Polishing thicknesses of the first surface and the second surface may be the same as each other or be different from each other.

Although not illustrated in FIGS. 7 and 8, a shape machining process may be further performed, if necessary, after the surface polishing process after strengthening (S6). For example, when the glass articles 101 to 103 having the three-dimensional shape illustrated in FIG. 1 are prepared, a three-dimensional processing process may be performed after the surface polishing process after strengthening (S6) is completed.

The glass article 100 prepared through the above-described process may include a component ratio similar to that of the glass composition. For example, the glass article 100 may include about 60 mol% to about 75 mol% of $SiO_2$,

about 3 mol% to about 10 mol% of $Al_2O_3$, about 3 mol% to about 10 mol% of $Na_2O$, about 10 mol% to about 25 mol% of $Li_2O$, 0 mol% to about 1 mol% of $P_2O_5$, and about 1 mol% to about 5 mol% of $ZrO_2$, wherein each amount is based on 100 mole percent total of the glass article. In addition, a glass article 100 according to another embodiment may further include $K_2O$ in an amount of 0 mol% to about 1 mol%, based on 100 mole percent total of the glass article in addition to the above-described component ratio. The glass composition for preparing the glass article 100 satisfies Mathematical Expression 1:

Mathematical Expression 1

$$0.1 < Al_2O_3/R_2O < 0.5$$

wherein, ($R_2O$) represents a total mole percent of $Na_2O$ and $Li_2O$ combined, and ($Al_2O_3$) represents mole percent of $Al_2O_3$.

In addition, when the glass article further includes $K_2O$, ($R_2O$) in Mathematical Expression 1 may be expressed as ($R'_2O$), which represents a total mole percent of Li, Na, and K combined.

The glass article 100 prepared from the above-described glass composition has a thickness in the range of about 20 $\mu$m to about 100 $\mu$m.

In one or more embodiments, the glass article 100 prepared from the above-described glass composition has a thickness in the range of about 20 $\mu$m to about 100 $\mu$m and may satisfy one or more of the following properties:

i) A coefficient of thermal expansion of about $75 \times 10^{-7}$ $K^{-1}$ to about $85 \times 10^{-7}$ $K^{-1}$.
ii) A glass transition temperature ($T_g$) of about 450°C to about 550°C.
iii) A density of about 2.4 grams per cubic centimeter ($g/cm^3$) to about 2.6 $g/cm^3$.
iv) An elastic modulus of about 75 gigapascal (GPa) to about 85 GPa.
v) A Poisson's ratio of about 0.3 to about 0.4.
vi) A hardness of about 5.5 GPa to about 6.5 GPa.
vii) A fracture toughness of about 1.0 megapascal square root meters ($MPa*m^{0.5}$) to about 1.5 $MPa*m^{0.5}$.
viii) A brittleness of about 4.5 $\mu m^{-0.5}$ to about 5.5 $\mu m^{-0.5}$.

Hereinafter, one or more exemplary embodiments will be described through the Preparation Examples and Experimental Examples.

EXAMPLES

Preparation Example 1: Preparation of Glass Article

A plurality of glass base materials having various compositions were prepared according to Table 1 and were divided into Examples 1 to 4, and a glass article was prepared by processing according to the method described above was then performed for each sample. Glass articles for each sample were prepared as articles having a thickness of 50 $\mu$m.

The compositions of glass articles for each of Examples 1 to 4 are shown in Table 1. In addition, the properties such as density, glass transition temperature ($T_g$), hardness, fracture toughness, brittleness, elastic modulus, coefficient of thermal expansion (CTE), and Poisson's ratio of the glass articles for each sample were measured and shown in Table 2.

Here, specimens having 5 g of each composition were manufactured, and glass transition temperatures ($T_g$) of the specimens were confirmed using a differential thermal analyzer (DTA) while raising temperatures of the specimens to a glass transition temperature range at a rate of 10 K/min. Specimens having a size of $10 \times 10 \times 13$ $mm^3$ were manufactured for each composition, and coefficients of thermal expansion of the specimens were confirmed using a thermal mechanical analyzer (TMA) while raising temperatures of the specimens to a glass transition temperature range at a rate of 10 K/min.

Specimens having a size of $10 \times 20 \times 3$ $mm^3$ were manufactured for each composition, and elastic moduli and Poisson ratios of the specimens were confirmed using an elastic modulus tester by confirming stresses and strains of the specimens.

Hardnesses and fracture toughnesses of specimens were calculated by Equations (3) and (4) by applying a load of 4.9 N to the specimens for 30 seconds with a Vickers hardness tester using a diamond tip having a size of 19 $\mu$m.

$$H_V = 1.854 \cdot \frac{F}{a^2} \qquad (3)$$

Here, Hv refers to a Vickers hardness, F refers to a load, and a refers to an indentation length.

$$\frac{K_{IC} \cdot \phi}{H_V \cdot a^{\frac{1}{2}}} = 0.15 \cdot K \cdot \left(\frac{c}{a}\right)^{-\frac{3}{2}} \quad (4)$$

Here, $K_{IC}$ refers to a fracture toughness, $\phi$ refers to a constraint index ($\phi \approx 3$), Hv refers to a Vickers hardness, K refers to a constant (= 3.2), c refers to a crack length, and a refers to an indentation length.

Brittlenesses of specimens were calculated by Equation (5) by applying a load of 4.9 N to the specimens for 30 seconds using a Vickers hardness tester.

$$B = \gamma \, P^{-1/4} \frac{C^{3/2}}{a} \quad (5)$$

Here, B refers to a brittleness, $\gamma$ refers to a constant (2.39 $N^{1/4}/ \mu m^{1/2}$), P refers to an indentation load, a refers to an indentation length, and C refers to a crack length.

Table 1

|  | Example 1 | Example 2 | Example 3 | Example 4 |
|---|---|---|---|---|
| $SiO_2$ | 67.2 | 70.0 | 68.9 | 67.1 |
| $Al_2O_3$ | 6.3 | 7.7 | 10.3 | 11.3 |
| $B_2O_3$ | - | - | - | 0.4 |
| MgO | - | 7.5 | 5.4 | 4.7 |
| $P_2O_5$ | 0.2 | - | - | - |
| $Na_2O$ | 5.0 | 12.7 | 15.2 | 14.8 |
| $K_2O$ | 0.1 | 1.7 | - | 1.4 |
| $Li_2O$ | 18.7 | - | - | - |
| $ZrO_2$ | 2.4 | - | - | - |
| $(Al_2O_3)/(R_2O)$ | 0.26 | 0.53 | 0.68 | 0.70 |

Table 2

| Property | Example 1 | Example 2 | Example 3 | Example 4 |
|---|---|---|---|---|
| Density (g/cm$^3$) | 2.485 | 2.46 | 2.42 | 2.45 |
| $T_g$ (°C) | 478 | 602 | 599 | 560 |
| Hardness (GPa) | 6.09 | 6.05 | 5.24 | 5.79 |
| Fracture Toughness (MPa*m$^{0.5}$) | 1.21 | 0.70 | 0.68 | 0.67 |
| Brittleness ($\mu$m$^{-0.5}$) | 5.05 | 8.64 | 7.71 | 8.64 |
| Elastic Modulus (GPa) | 82 | 74 | 71.5 | 70 |
| CTE (10$^{-7}$ K$^{-1}$) | 81.6 | 88 | 80 | 91 |
| Poisson's Ratio | 0.353 | 0.215 | 0.210 | 0.200 |

Referring to Tables 1 and 2, Example 1 was a glass article made of a glass composition including $Li_2O$, $ZrO_2$, and $P_2O_5$. In addition, Examples 2 to 4 were glass articles made of glass compositions that do not contain $Li_2O$, $ZrO_2$,

or $P_2O_5$.

It can be seen that a glass transition temperature of Example 1 is 478°C, which was significantly lower than the glass transition temperatures of Examples 2 to 4. This may mean that meltability and processability of a glass in Example 1 were excellent.

In addition, it could be seen that a fracture toughness of Example 1 was 1.21 MPa*m$^{0.5}$ and a brittleness of Example 1 was 5.05 $\mu$m$^{-0.5}$. On the other hand, the fracture toughness of Examples 2 to 4 was 0.7 MPa*m$^{0.5}$ or less, and the brittleness of Examples 2 to 4 were 7.71 $\mu$m$^{-0.5}$ or greater. Accordingly, it can be seen that Example 1 has excellent shock resistance properties as compared with Examples 2 to 4.

In addition, it could be seen that an elastic modulus of Example 1 was 81.6 GPa and a Poisson's ratio of Example 1 was 0.353. On the other hand, the elastic modulus of Examples 2 to 4 were 74 GPa or less, and the Poisson's ratios of Examples 2 to 4 were 0.215 or less. Accordingly, it can be seen that Example 1 has excellent flexibility as compared with Examples 2 to 4.

While the present disclosure has been illustrated and described with reference to exemplary embodiments thereof, it will be understood by those of ordinary skill in the art that various suitable changes in form and detail may be made therein without departing from the scope of the present disclosure as defined by the following claims. The exemplary embodiments should be considered in a descriptive sense only and not for purposes of limitation.

**Claims**

1. A glass composition, comprising:

   about 60 mole percent to about 75 mole percent of $SiO_2$;
   about 3 mole percent to about 10 mole percent of $Al_2O_3$;
   about 3 mole percent to about 10 mole percent of $Na_2O$;
   about 10 mole percent to about 25 mole percent of $Li_2O$;
   0 mole percent to about 1 mole percent of $P_2O_5$; and
   about 1 mole percent to about 5 mole percent of $ZrO_2$,
   wherein each amount is based on 100 mole percent total of the glass composition, and
   wherein the glass composition satisfies Mathematical Expression 1:

$$\text{Mathematical Expression 1}$$

$$0.1 < Al_2O_3/R_2O < 0.5$$

   wherein,
   ($R_2O$) represents a total mole percent of $Na_2O$ and $Li_2O$ combined, and
   ($Al_2O_3$) represents mole percent of $Al_2O_3$.

2. The glass composition of claim 1, comprising:

   about 67.2 mole percent of $SiO_2$,
   about 6.3 mole percent of $Al_2O_3$,
   about 5.1 mole percent of $Na_2O$,
   about 18.7 mole percent of $Li_2O$,
   wherein each amount is based on 100 mole percent total of the glass composition, and
   a ratio of ($Al_2O_3$)/($R_2O$) is 0.26.

3. The glass composition of claim 1, further comprising 0 mole percent to about 1 mole percent of $K_2O$, based on 100 mole percent total of the glass composition.

4. The glass composition of claim 3, comprising:

   about 67.2 mole percent of $SiO_2$;
   about 6.3 mole percent of $Al_2O_3$;
   about 5.0 mole percent of $Na_2O$;
   about 18.7 mole percent of $Li_2O$;

about 0.1 mole percent of $K_2O$
wherein a ratio of $(Al_2O_3)/(R'_2O)$ is 0.26, and
wherein $(R'_2O)$ represents a total mole percent of $Na_2O$, $Li_2O$, and $K_2O$ combined.

5. The glass composition of claim 4, wherein a total amount of $Na_2O$, $Li_2O$, and $K_2O$ is about 20 mole percent to about 25 mole percent, based on 100 mole percent total of the glass composition.

6. The glass composition of at least one of claims 1 to 4, wherein a total amount of $Na_2O$ and $Li_2O$ in the glass composition is about 20 mole percent to about 25 mole percent, based on 100 mole percent total of the glass composition.

7. A glass article (100), comprising a glass composition according to at least one of claims 1 to 6 wherein a thickness of the glass article (100) is in a range of about 20 micrometers to about 100 micrometers.

8. The glass article (100) of claim 7, wherein a coefficient of thermal expansion of the glass article (100) is in a range of about $75 \times 10^{-7}$ $K^{-1}$ to about $85 \times 10^{-7}$ $K^{-1}$.

9. The glass article (100) of claim 7 or 8, wherein the glass article (100) has a glass transition temperature of about 450°C to about 550°C, as determined by .

10. The glass article (100) of at least one of claims 7 to 9, wherein the glass article (100) has a density of about 2.4 grams per cubic centimeter to about 2.6 grams per cubic centimeter.

11. The glass article (100) of at least one of claims 7 to 10, wherein the glass article (100) has an elastic modulus of about 75 gigapascal to about 85 gigapascal.

12. The glass article (100) of at least one of claims 7 to 11, wherein the glass article (100) has a Poisson's ratio of about 0.3 to about 0.4.

13. The glass article (100) of at least one of claims 7 to 12, wherein the glass article (100) has a hardness of about 5.5 gigapascal to about 6.5 gigapascal.

14. The glass article (100) of at least one of claims 7 to13, wherein the glass article (100) has a fracture toughness of about 1.0 megapascal square root meters to about 1.5 megapascal square root meters.

15. The glass article (100) of at least one of claims 7 to 14, wherein the glass article (100) has a brittleness index that is about 4.5 $\mu m^{-0.5}$ to about 5.5 $\mu m^{-0.5}$.

16. A display device (500), comprising:

a display panel (200) comprising a plurality of pixels;
a cover window disposed on the display panel (200); and
an optically clear coupling layer (300) disposed between the display panel (200) and the cover window,
wherein the cover window comprises a glass composition according to at least one of claims 1 to 6 or is a glass article (100) according to at least one of claims 7 to 15.

# FIG. 1

# FIG. 2

# FIG. 3

# FIG. 4

500

# FIG. 5

**FIG. 6**

# FIG. 7

```
          ┌─────────────┐
          │    START    │
          └──────┬──────┘
                 ▼
┌───────────────────────────────────┐  S1
│           FORMING STEP            │
└──────────────────┬────────────────┘
                   ▼
┌───────────────────────────────────┐  S2
│           CUTTING STEP            │
└──────────────────┬────────────────┘
                   ▼
┌───────────────────────────────────┐  S3
│      SIDE SURFACE POLISHING STEP   │
└──────────────────┬────────────────┘
                   ▼
┌───────────────────────────────────┐  S4
│       SURFACE POLISHING STEP       │
│        BEFORE STRENGTHENING        │
└──────────────────┬────────────────┘
                   ▼
┌───────────────────────────────────┐  S5
│         STRENGTHENING STEP         │
└──────────────────┬────────────────┘
                   ▼
┌───────────────────────────────────┐  S6
│       SURFACE POLISHING STEP       │
│        AFTER STRENGTHENING         │
└──────────────────┬────────────────┘
                   ▼
          ┌─────────────┐
          │     END     │
          └─────────────┘
```

# FIG. 8

**Europäisches Patentamt**
**European Patent Office**
**Office européen des brevets**

# EUROPEAN SEARCH REPORT

Application Number

EP 23 16 2320

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/370264 A1 (OHARA SEIKI [JP] ET AL) 18 December 2014 (2014-12-18) * paragraphs [0001], [0077]; tables 2,3 * | 1,6-16 | INV. C03C3/097 C03C21/00 |
| X | WO 2021/068423 A1 (QINGYUAN CSG NEW ENERGY SAVING MAT CO LTD [CN] ET AL.) 15 April 2021 (2021-04-15) * the whole document * | 1-6 | |
| X | US 2012/264585 A1 (OHARA SEIKI [US] ET AL) 18 October 2012 (2012-10-18) * paragraphs [0001], [0067]; examples 16,23; tables 2,3 * | 1,6-16 | |
| X | WO 2021/121404 A1 (CHONGQING AUREAVIA HI TECH GLASS CO LTD [CN]) 24 June 2021 (2021-06-24) * the whole document * -& EP 4 079 698 A1 (CHONGQING AUREAVIA HI TECH GLASS CO LTD [CN]) 26 October 2022 (2022-10-26) | 1-5 | |
| | | | TECHNICAL FIELDS SEARCHED (IPC) |
| X | DE 20 2022 100419 U1 (CHONGQING AUREAVIA HI TECH GLASS CO LTD [CN]) 18 February 2022 (2022-02-18) * example 6 * | 1,6 | C03C |

The present search report has been drawn up for all claims

| Place of search | Date of completion of the search | Examiner |
|---|---|---|
| Munich | 10 August 2023 | King, Ruth |

EPO FORM 1503 03.82 (P04C01)

**ANNEX TO THE EUROPEAN SEARCH REPORT
ON EUROPEAN PATENT APPLICATION NO.**

EP 23 16 2320

This annex lists the patent family members relating to the patent documents cited in the above-mentioned European search report.
The members are as contained in the European Patent Office EDP file on
The European Patent Office is in no way liable for these particulars which are merely given for the purpose of information.

10-08-2023

| Patent document cited in search report | | Publication date | Patent family member(s) | | | Publication date |
|---|---|---|---|---|---|---|
| US 2014370264 | A1 | 18-12-2014 | CN | 103999140 | A | 20-08-2014 |
| | | | CN | 105439445 | A | 30-03-2016 |
| | | | JP | 5293908 | B1 | 18-09-2013 |
| | | | JP | WO2013088856 | A1 | 27-04-2015 |
| | | | KR | 20140103953 | A | 27-08-2014 |
| | | | KR | 20150040367 | A | 14-04-2015 |
| | | | TW | 201326067 | A | 01-07-2013 |
| | | | TW | 201604150 | A | 01-02-2016 |
| | | | US | 2014370264 | A1 | 18-12-2014 |
| | | | US | 2017217824 | A1 | 03-08-2017 |
| | | | US | 2018037498 | A1 | 08-02-2018 |
| | | | US | 2018044232 | A1 | 15-02-2018 |
| | | | WO | 2013088856 | A1 | 20-06-2013 |
| WO 2021068423 | A1 | 15-04-2021 | CN | 110615611 | A | 27-12-2019 |
| | | | WO | 2021068423 | A1 | 15-04-2021 |
| US 2012264585 | A1 | 18-10-2012 | CN | 102745896 | A | 24-10-2012 |
| | | | JP | 2012232882 | A | 29-11-2012 |
| | | | KR | 20120118409 | A | 26-10-2012 |
| | | | TW | 201245079 | A | 16-11-2012 |
| | | | US | 2012264585 | A1 | 18-10-2012 |
| | | | US | 2014364298 | A1 | 11-12-2014 |
| WO 2021121404 | A1 | 24-06-2021 | CN | 110981206 | A | 10-04-2020 |
| | | | EP | 4079698 | A1 | 26-10-2022 |
| | | | KR | 20220117309 | A | 23-08-2022 |
| | | | US | 2023031267 | A1 | 02-02-2023 |
| | | | WO | 2021121404 | A1 | 24-06-2021 |
| EP 4079698 | A1 | 26-10-2022 | CN | 110981206 | A | 10-04-2020 |
| | | | EP | 4079698 | A1 | 26-10-2022 |
| | | | KR | 20220117309 | A | 23-08-2022 |
| | | | US | 2023031267 | A1 | 02-02-2023 |
| | | | WO | 2021121404 | A1 | 24-06-2021 |
| DE 202022100419 | U1 | 18-02-2022 | CN | 112694258 | A | 23-04-2021 |
| | | | DE | 202022100419 | U1 | 18-02-2022 |
| | | | EP | 4036070 | A1 | 03-08-2022 |
| | | | JP | 2022117461 | A | 10-08-2022 |
| | | | KR | 20220110104 | A | 05-08-2022 |
| | | | US | 2022242776 | A1 | 04-08-2022 |

EPO FORM P0459

For more details about this annex : see Official Journal of the European Patent Office, No. 12/82